# EUROPÄISCHE PATENTSCHRIFT

(11) **EP 0 695 249 B1**
(45) Veröffentlichungstag und Bekanntmachung des Hinweises auf die Patenterteilung: **05.03.1997**
(21) Anmeldenummer: 94913584.2
(22) Anmeldetag: 13.04.1994
(51) Int. Cl.: B60T 8/36

(54) **ELEKTROHYDRAULISCHE DRUCKREGELVORRICHTUNG**
ELECTRO-HYDRAULIC PRESSURE REGULATING DEVICE
REGULATEUR ELECTRO-HYDRAULIQUE DE PRESSION

(30) Priorität: 30.04.1993 DE 4314312
(43) Veröffentlichungstag der Anmeldung: 07.02.1996
(73) Patentinhaber: ITT Automotive Europe GmbH, 60488 Frankfurt am Main (DE)
(72) Erfinder: STEFFES, Helmut, D-65795 Hattersheim (DE)
(86) Internationale Anmeldenummer: EP9401135
(87) Internationale Veröffentlichungsnummer: WO9425320

(56) Entgegenhaltungen:
- EP-A- 0 499 670
- WO-A-89/10286
- WO-A-92/08630
- WO-A-92/12878
- WO-A-92/22104
- US-A- 4 083 902

## Beschreibung

Die Erfindung betrifft eine elektrohydraulische Druckregelvorrichtung, insbesondere Bremsdruckregelvorrichtung nach dein Oberbegriff des Anspruchs 1, sowie ein Verfahren zur Herstellung einer solchen Druckregelvorrichtung dazu.

Eine elektrohydraulische Druckregelvorrichtung der gattungsbildenden Art wird beispielhaft in der internationalen Veröffentlichung WO 92/12878 beschrieben, wonach über die bereits hinreichend bekannte Blockbauweise des Ventilaufnahmekörpers hinaus der Deckel mittels eines plattenförmigen Trägerelementes unterteilt ist, um einerseits einen elektronischen Regler oder Teile eines elektronischen Reglers aufzunehmen, andererseits die elektrische Verbindung zwischen dein elektronischen Regler und den an den Elektromagnetventilen überstehenden Kontaktelementen herzustellen. Der Deckel ist mit den Spulen der Elektromagnetventile auf die Ventildome des Ventilaufnahmekörpers aufgesteckt, wobei zur Herstellung des elektrischen Anschlusses zwischen den Kontaktelementen und den im Deckel integrierten elektronischen bzw. elektrischen Komponenten Steckkontakte ineinandergreifen. Zur Befestigung der Spulen am Trägerelement wird vorgeschlagen, elastische Halterungen, beispielsweise Federn zu verwenden oder die Spulen in einem elastischen Formkörper einzubetten. Beide Varianten bedürfen einer Vereinfachung.

Folglich ist es die Aufgabe der Erfindung, die aus dem genannten Stand der Technik bekannte Druckregelvorrichtung zu verbessern, um eine kompakte sowie funktionsoptimierte Vereinigung der Spulen mit dem Trägerelement zu schaffen, die möglichst einfach herzustellen und zu prüfen ist, wobei unterschiedliche Wärmedehnungen der Bauteile möglichst spannungsfrei aufgenommen werden sollen. Ferner soll ein geeignetes Verfahren zur Herstellung einer solchen Druckregelvorrichtung geschaffen werden.

Die gestellten Aufgaben werden erfindungsgemäß durch die kennzeichnenden Merkmale des Patentanspruchs 1 sowie betreffend des Verfahrens durch den Patentanspruch 8 gelöst. Hierzu wird vorgeschlagen, daß an der den Spulen zugewandten Unterseite des Trägerelementes Vorsprünge angeordnet sind, die die aus den Spulen hervorragenden elektrischen Kontaktelemente umschließen, wobei in den Vorsprüngen Hohlräume zur Aufnahme von Klebstoffmasse vorgesehen sind, die eine die Kontaktelemente kraftschlüssig umschließende Verbindung mit den Vorsprüngen herstellt. Hinsichtlich des Herstellungsverfahrens wird vorgeschlagen, die Kontaktelemente bzw. die Hohlräume der Vorsprünge mit Klebstoffmasse in Form von Heißkleberpillen zu versehen, die nach dem Verlöten der elektrischen Leiterbahnen geschmolzen werden, wobei zum Zwecke einer korrosionsgeschützten Versiegelung der elektrischen Kontaktierung das Trägerelement mit einer schnell aushärtbaren Vergußmasse versehen wird oder alternativ ein das Trägerelement begrenzender Rahmen eine Abdeckung bildet, die entweder verklebt oder verschweißt am Trägerelement gehalten wird.

Weitere Merkmale, Vorteile und Anwendungsmöglichkeiten gehen aus der folgenden Darstellung zweier Ausführungsbeispiele hervor.

Es zeigen:
- Figur 1: zwei alternative Ausführungsformen vereinigt in einer Seitenansicht der erfindungsgemäßen Druckregelvorrichtung im Teilschnitt,
- Figur 2: eine in Figur 1 räumlich hinter den beiden Spulen gelegenen Schnittebene, die Anordnung des Befestigungselementes für die beiden alternativen Ausführungsformen des Trägerelementes.

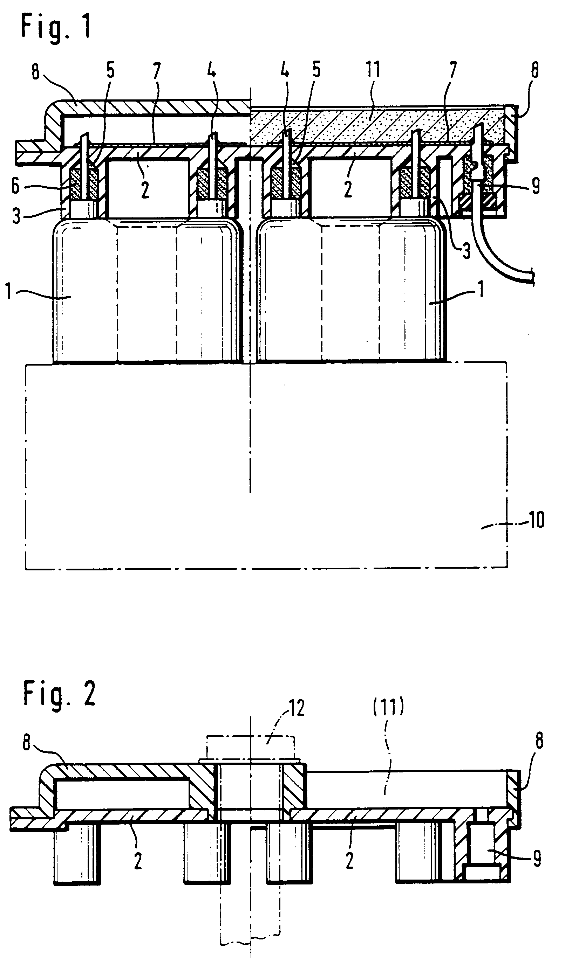

Die Figur 1 zeigt eine Seitenansicht der erfindungsgemäßen Druckregelvorrichtung mit einer Skizzierung der Grundkomponenten. Die zur senkrechten Körpersymmetrieachse dargestellte linke Hälfte der Druckregelvorrichtung besteht in einer ersten Ausführungsform aus einem im Profilschnitt gezeigten Deckel, der aus einem mehrere Leiterbahnen 7 aufweisenden Trägerelement 2 und einem darüber zu einer Abdeckung geformten Rahmen 8 gebildet ist. Die zur senkrechten Körpersymmetrieachse dargestellte rechte Hälfte der Druckregelvorrichtung weist eine weitere alternative Ausführungsform der Spulenabdeckung auf, wonach das mit Leiterbahnen 7 versehene Trägerelement 2 mit einem Rahmen 8 versehen ist, in den antikorrosive Vergußmasse 11 zur Abdeckung der Leiterbahnen 7 und den damit in Verbindung stehenden Spulen-Kontaktelementen 4 eingefüllt ist. Unabhängig von der gewählten Einzelbetrachtung der beiden Ausführungsvarianten zur Spulenabdeckung, ist das Trägerelement 2 als im wesentlichen horizontal auf die Kontaktelemente 4 der Spulen 1 aufgesetzte Formleiterplatte ausgeführt, die auf ihrer Unterseite angeformte Vorsprünge 3 aufweist, die die aus den Spulen 1 hervor ragenden Kontaktelemente 4 überdecken. Die zwischen den Kontaktelementen 4 und den hülsenförmigen Vorsprüngen 3 gebildeten Hohlräume 5 nehmen vorzugsweise als Heißklebepillen ausgeführte Klebstoffmassen 6 auf, die eine kraftschlüssig umschliessende Verbindung des Trägerelementes 2 mit der Spule 1 herstellen. Der blockförmige Ventilaufnahmekörper 10 ist entweder aus Stahl oder Leichtmetall gefertigt und mit Ventildomen versehen, die in der Abbildung strichliniert, jedoch nicht explizit dargestellt sind. Auf den in zwei parallelen Reihen angeordneten Ventildomen werden die am Trägerelement 2 elastisch verankerten Spulen 1 übergestülpt. Da das Trägerelement 2 als Formleiterplatte gestaltet ist, kann die an die Leiterbahnen 7 angeschlossene elektrische Steckverbindung 9 vorzugsweise als homogenes Bestandteil des Trägerelementes 2, zwecks Anschluß eines peripheren Kabelstrangs, angeformt sein. Die Kontaktelemente 4 der Spulen 1 werden in den Ausstanzungen im Trägerelement 2 bzw. in den Leiterbahnen verlötet.

Die Figur 2 zeigt einen senkrecht und damit räumlich in Richtung der Blattebene versetzten Profilschnitt des Trägerelementes 2 und zwar zwischen zwei hintereinander liegenden Spulenpaaren. Wie bereits aus Figur 1 hervorgegangen ist, weist das Trägerelement 2 gleichfalls die beiden alternativen Ausgestaltungsformen zur Rahmenabdeckung auf. Links im Bild befindet sich der zu einer geschlossenen Abdeckung ausgeformte Rahmen 8. Rechts im Bild ist zur Aufnahme von Vergußmasse 11 der Rahmen 8 als offenes Rahmenteil ausgeführt. Das Trägerelement 2 ist in der Mitte von einem als Schraube ausgebildeten Befestigungselement 12 durchdrungen, das das Trägerelement 2 mit den Spulen 1 auf dem Ventilaufnahmekörper 10 fixiert. Der zu einer Abdeckung ausgeformte Rahmen 8 ist entweder auf das Trägerelement 2 aufgeklebt oder unter der Voraussetzung gleicher Materialien (Kunststoff) miteinander verschweißt. Im Falle der Verwendung eines offenen Rahmens 8 ist eine möglichst schnell aushärtende Vergußmasse 11 erwünscht, was durch die Anwendung von UV-Strahlung begünstigt wird. Die beschriebene Druckregelvorrichtung gewährleistet eine relativ einfache Anpassung einzelner Komponenten an unterschiedliche Fertigungsbelange. Die erforderlichen elektrischen bzw. elektronischen Komponenten sowie Bestandteile hierzu (Trägerplatte, Kontaktierung) werden als separate Baugruppe "Elektrik" optimal an die jeweiligen Bedürfnisse des Hydraulikteils (Ventilblocks) angepaßt. Ferner können durch die vorbeschriebene stoffliche Verbindung zwischen dem Trägerelement, den Spulen und der Rahmenabdeckung in vorteilhafterweise alle Elemente an die derzeit praktizierten Fertigungstechniken angepaßt werden. Überdies lassen sich durch eine elastische oder gegebenenfalls auch plastische Verankerung der Spulen am Trägerelement die mechanische Beanspruchung, u.a. hervorgerufen durch thermomechanische Spannung, minimieren.

### Bezugszeichenliste

- 1: Spule
- 2: Trägerelement
- 3: Vorsprung
- 4: Kontaktelement
- 5: Hohlraum
- 6: Klebstoffmassen
- 7: Leiterbahn
- 8: Rahmen
- 9: Steckverbindung
- 10: Ventilaufnahmekörper
- 11: Vergußmasse
- 12: Befestigungselement

## Patentansprüche

1. Elektrohydraulische Druckregelvorrichtung, insbesondere Bremsdruckregelvorrichtung, wie Antiblockierregelvorrichtung, Antriebsschlupfregelvorrichtung, mit elektromagnetisch betätigbaren Hydraulikventilen, die an einem Ventilaufnahmekörper (10) angeordnet sind, mit Spulen (1), die den Ventilaufnahmekörper (10) überragen, wobei die Spulen (1) an ihren den Ventilaufnahmekörper (10) überragenden Teilen mit elektrischen Kontaktelementen (4) versehen sind, mit einem Deckel, der die überragenden Spulenteile und die Kontaktelemente (4) abdeckt, mit einem im wesentlichen plattenförmigen Trägerelement (2) zur Aufnahme der Spulen (1), das einen Teil des Deckels bildet, wobei der Deckel oder ein Teil des Deckels als elektronischer Regler oder als ein Teil eines elektronischen Reglers ausgebildet ist, dadurch **gekennzeichnet**, daß an der den Spulen (1) zugewandten Unterseite des Trägerelementes (2) Vorsprünge (3) angeformt sind, die die aus den Spulen (1) hervor ragenden elektrischen Kontaktelemente (4) umschließen, und daß in den Vorsprüngen (3) Hohlräume (5) mit einer Klebstoffmasse (6) versehen sind, die eine die Kontaktelemente (4) kraftschlüssig umschließende Verbindung mit den Vorsprüngen (3) herstellt.

2. Elektrohydraulische Druckregelvorrichtung nach Anspruch 1, dadurch **gekennzeichnet**, daß auf der von den Spulen (1) abgewandten Oberseite des Trägerelementes (2) elektrische Leiterbahnen (7), vorzugsweise auf einer oder mehreren Leiterplatten, vorgesehen sind, die von einem Rahmen (8) begrenzt sind.

3. Elektrohydraulische Druckregelvorrichtung nach Anspruch 1 oder 2, dadurch **gekennzeichnet**, daß ein weiterer Vorsprung des Trägerelementes (2) zu einer elektrischen Steckverbindung (9) ausgeformt ist.

4. Elektrohydraulische Druckregelvorrichtung nach einem der vorhergehenden Ansprüche 1 bis 3, dadurch **gekennzeichnet**, daß das Trägerelement (2) mit dem Rahmen (8) von wenigstens einem Befestigungselement (12) durchdrungen ist, daß das Trägerelement (2) am Ventilaufnahmekörper (10) fixiert.

5. Elektrohydraulische Druckregelvorrichtung wenigstens nach Anspruch 2, dadurch **gekennzeichnet**, daß der Rahmen eine antikorrosive Vergußmasse (11) aufnimmt, die die Leiterbahnen (7) und die Kontaktelemente (4) abdeckt.

6. Elektrohydraulische Druckregelvorrichtung wenigstens nach Anspruch 2, dadurch **gekennzeichnet**, daß der Rahmen (8) aus einer die Leiterbahn (7) umschließenden Abdeckung gebildet ist, die mit dem Trägerelement (2) zu einem Deckel verklebt oder verschweißt ist.

7. Elektrohydraulische Druckregelvorrichtung wenigstens nach Anspruch 2, dadurch **gekennzeichnet**, daß der Rahmen (8) und das Trägerelement (2) aus einer elastischen Kunststoffverbindung bestehen.

8. Verfahren zur Herstellung einer elektrohydraulischen Druckregelvorrichtung, insbesondere Bremsdruckregelvorrichtung, wie Antiblockierregelvorrichtung, Antriebsschlupfregelvorrichtung, mit elektromagnetisch betätigbaren Hydraulikventilen (Elektromagnetventilen), die an einem Ventilaufnahmekörper (10) angeordnet sind, mit Spulen (1), die den Ventilaufnahmekörper (10) überragen, wobei die Spulen (1) an ihren den Ventilaufnahmekörper (10) überragenden Teilen mit elektrischen Kontaktelementen (4) versehen sind, mit einem Deckel, der die überragenden Spulenteile und die Kontaktelemente (4) abdeckt, mit einem im wesentlichen plattenförmigen Trägerelement zur Aufnahme der Spulen (1), das einen Teil des Deckels bildet, wobei der Deckel oder ein Teil des Deckels als elektronischer Regler oder als ein Teil eines elektronischen Reglers ausgebildet ist, dadurch **gekennzeichnet**, daß auf den Kontaktelementen (4) der Spulen (1) Klebstoffmasse (6) in Form von Heißkleberpillen angeordnet wird, wobei die Kontaktelemente (4) und die Heißkleberpillen von Vorsprüngen (3) des Trägerelementes (2) derart überdeckt werden, daß die Kontaktelemente (4) auf der Oberseite des Trägerelementes (2) heraus ragen und danach in einer Lötvorrichtung, vorzugsweise im Schwallbadlötverfahren, mit den elektrischen Leiterbahnen (7) des Trägerelementes (2) verlötet werden, daß anschließend die Klebstoffmasse (6) geschmolzen wird, und daß danach über die herausragenden, gelöteten Kontaktelemente (4) entweder schnell aushärtende Vergußmasse (11) in einen am Trägerelement (2) versehenen Rahmen (8) eingebracht wird, oder ein zu einem Deckel ausgeformter Rahmen (8) dicht auf dem Trägerelement (2) verklebt oder verschweißt befestigt wird.

9. Verfahren zur Herstellung einer Druckregelvorrichtung nach Anspruch 8, dadurch **gekennzeichnet**, daß die Vergußmasse (11) im Rahmen (8) des Trägerelementes (2) mittels Ultraviolett-Bestrahlung ausgehärtet wird.

## Claims

1. Electrohydraulic pressure control device, in particular a braking pressure control device, such as an anti-lock control device or traction slip control device, including electromagnetically operable hydraulic valves arranged on a valve-accommodating member (10), coils (1) which project from the valve-accommodating member (10), the coils (1) having electric contact elements (4) on their parts projecting from the valve-accommodating member (10), a cover which covers the projecting coil parts and the contact elements (4), a substantially plate-shaped carrier element (2) for accommodating the coils (1) which is arranged within the cover, the cover or part of the cover being provided as an electronic controller or as a part of an electronic controller,
**characterized** in that projections (3) are formed on the bottom side of the carrier element (2), which bottom side faces the coils (1), with the projections enclosing the electric contact elements (4) which project from the coils (1), and in that cavities (5) in the projections (3) include adhesive material (6) which establishes a connection with the projections (3) by enclosing the contact elements (4) in an operative manner.

2. Electrohydraulic pressure control device as claimed in claim 1,
**characterized** in that, on the upper side of the carrier element (2) remote from the coils (1), electric conducting paths (7) are provided, preferably on one or a plurality of printed circuit boards, which are bounded by a frame (8).

3. Electrohydraulic pressure control device as claimed in claim 1 or 2,
**characterized** in that another projection of the carrier element (2) is formed to provide an electric plug connection (9).

4. Electrohydraulic pressure control device as claimed in any one of the preceding claims 1 to 3,
**characterized** in that at least one attaching element (12) extends through the carrier element (2) with the frame (8) and fixes the carrier element (2) on the valve-accommodating member (10).

5. Electrohydraulic pressure control device at least as claimed in claim 2,
**characterized** in that the frame accommodates an anti-corrosion sealing compound (11) which covers the conducting paths (7) and the contact elements (4).

6. Electrohydraulic pressure control device at least as claimed in claim 2,
**characterized** in that the frame (8) is formed of a covering which encloses the conducting path (7) and is cemented or welded with the carrier element (2) to form a cover.

7. Electrohydraulic pressure control device at least as claimed in claim 2,
**characterized** in that the frame (8) and the carrier element (2) are made of an elastic plastic compound.

8. Method of manufacturing an electrohydraulic pressure control device, in particular a braking pressure control device, such as an anti-lock control device or traction slip control device, including electromagnetically operable hydraulic valves (solenoid valves) arranged on a valve-accommodating member (10), coils (1) which project from the valve-accommodating member (10), the coils (1) having electric contact elements (4) on their parts projecting from the valve-accommodating member (10), a cover which covers the projecting coil parts and the contact elements (4), a substantially plate-shaped carrier element for accommodating the coils (1) which is arranged within the cover, with the cover or part of the cover being provided as an electronic controller or as a part of an electronic controller,
**characterized** in that adhesive material (6) in the form of hot-setting adhesive pills is arranged on the contact elements (4) of the coils (1), with the contact elements (4) and the hot-setting adhesive pills being covered by the projections (3) of the carrier element (2) such that the contact elements (4) project from the upper side of the carrier element (2) and are subsequently soldered with the electric conducting paths (7) of the carrier element (2) in a soldering device, preferably by wave soldering, in that subsequently the adhesive material (6) is melted, and in that thereafter either a quickly hardening sealing compound (11) is introduced into a frame (8) on the carrier element (2) over the projecting soldered contact elements (4), or a frame (8) formed to provide a cover is sealedly attached to the carrier element (2) by cementing or welding.

9. A method of manufacturing a pressure control device as claimed in claim 8,
**characterized** in that the sealing compound (11) is hardened in the frame (8) of the carrier element (2) by ultraviolet radiation.

## Revendications

1. Dispositif électro-hydraulique de régulation de pression, notamment dispositif de régulation de pression de freinage, tel que dispositif de régulation antiblocage, dispositif de régulation du glissement de traction, comprenant des valves hydrauliques à actionnement électromagnétique, qui sont disposées sur un corps de logement de valves (10), des bobines (1) qui dépassent du corps de logement de valves (10), les bobines (1) étant pourvues d'éléments de contact électrique (4) sur leur partie dépassant du corps de logement de valves (10), un couvercle, qui recouvre les parties de bobine qui dépassent et les éléments de contact (4), et un élément de support (2) pratiquement en forme de plaque qui sert à recevoir les bobines (1) et constitue une partie du couvercle, le couvercle ou une partie du couvercle étant réalisé sous forme d'un régulateur électronique ou d'une partie d'un régulateur électronique, caractérisé en ce que des parties en saillie (3) sont réalisées au formage sur la face inférieure de l'élément de support (2) qui est tournée vers les bobines (1), ces parties en saillie (3) entourant les éléments de contact électrique (4) qui dépassent des bobines (1), et en ce que, dans les parties en saillie (3), il est prévu des cavités (5) comportant une masse de substance adhésive (6) qui réalise une liaison avec les parties en saillie (3) qui entoure les éléments de contact (4) par complémentarité de formes.

2. Dispositif électro-hydraulique de régulation de pression selon la revendication 1, caractérisé en ce que, sur la face supérieure de l'élément de support (2) située à l'opposé des bobines (1), il est prévu des pistes électriquement conductrices (7), de préférence disposées sur une ou plusieurs plaques conductrices, qui sont délimitées par un cadre (8).

3. Dispositif électro-hydraulique de régulation de pression selon la revendication 1 ou 2, caractérisé en ce qu'une partie en saillie supplémentaire de l'élément de support (2) est réalisée par repoussage de façon à former une prise électrique (9).

4. Dispositif électro-hydraulique de régulation de pression selon l'une des revendications précédentes 1 à 3, caractérisé en ce que l'élément de support (2), avec le cadre (8), est traversé par au moins un élément de fixation (12) qui immobilise l'élément de support (2) sur le corps de logement de valve (10).

5. Dispositif électro-hydraulique de régulation de pression au moins selon la revendication 2, caractérisé en ce que le cadre reçoit une masse de remplissage par coulée (11) anticorrosive qui recouvre les pistes conductrices (7) et les éléments de contact (4).

6. Dispositif électro-hydraulique de régulation de pression au moins selon la revendication 2, caractérisé en ce que le cadre (8) est formé d'un élément de recouvrement, enveloppant les pistes conductrices (7), qui est collé ou soudé à l'élément de support (2) de façon à former un couvercle.

7. Dispositif électro-hydraulique de régulation de pression au moins selon la revendication 2, caractérisé en ce que le cadre (8) et l'élément de support (2) sont en une combinaison de matières plastiques qui est élastique.

8. Procédé de fabrication d'un dispositif électro-hydraulique de régulation de pression, notamment dispositif de régulation de pression de freinage, tel que dispositif de régulation antiblocage, dispositif de régulation du glissement de traction, comprenant des valves hydrauliques à actionnement électromagnétique (valves à électro-aimant), qui sont disposées sur un corps de logement de valves (10), des bobines (1) qui dépassent du corps de logement de valves (10), les bobines (1) étant pourvues d'éléments de contact électrique (4) sur leur partie dépassant du corps de logement de valves (10), un couvercle, qui recouvre les parties de bobine qui dépassent et les éléments de contact (4), et un élément de support (2) pratiquement en forme de plaque qui sert à recevoir les bobines (1) et constitue une partie du couvercle, le couvercle ou une partie du couvercle étant réalisé sous forme d'un régulateur électronique ou d'une partie d'un régulateur électronique, caractérisé en ce qu'on dispose des masses (6) de matière adhésive, sous forme de pastilles de substance thermo-adhésive, sur les éléments de contact (4) des bobines (1), les éléments de contact (4) et les pastilles de substance thermo-adhésive étant recouverts par les parties en saillie (3) de l'élément de support (2) d'une façon telle que les éléments de contact (4) dépassent de la face supérieure de l'élément de support (2), puis sont soudés avec les pistes électriquement conductrices (7) de l'élément de support (2) dans un dispositif de soudage, de préférence par le procédé de soudage en bain à la vague, et en ce qu'ensuite, on fait fondre la masse (6) de substance adhésive, puis, au-dessus des éléments de contact (4) soudés qui dépassent, ou bien on place une masse de remplissage par coulée (11), durcissant rapidement, dans un cadre (8) prévu sur l'élément de support (2), ou bien on fixe un cadre (8), réalisé par repoussage de façon à former un couvercle, d'une manière étanche sur l'élément de support (2) par collage ou soudage.

9. Procédé de fabrication d'un dispositif de régulation de pression selon la revendication 8, caractérisé en ce qu'on fait durcir la masse de remplissage par coulée (11) dans le cadre (8) de l'élément de support (2) au moyen d'un rayonnement ultraviolet.
